# EUROPEAN PATENT APPLICATION

(11) **EP 3 048 680 A1**
(43) Date of publication of application: **27.07.2016**
(21) Application number: 15290048.6
(22) Date of filing: 23.01.2015
(51) Int. Cl.: H01S 5/068, H01S 5/026, H01S 5/042

(54) **Transient wavelength drift reduction in semiconductor lasers**

(71) Applicant: ALCATEL LUCENT, 92100 Boulogne-Billancourt (FR)
(72) Inventor: Pfeiffer, Thomas, 70435 Stuttgart (DE)
(74) Representative: Reichl, Wolfgang

(57) **Abstract**

This application relates to a laser assembly displaying self-heating mitigation. The laser assembly comprises a semiconductor laser and a drive unit for driving the semiconductor laser. The semiconductor laser comprises: a first semiconductor region for generating or modulating an optical signal in response to a first drive current that is applied to the first semiconductor region, and a second semiconductor region that is arranged in proximity to the first semiconductor region and electrically insulated from the first semiconductor region. The drive unit Is configured to generate the first drive current and a second drive current, apply the first drive current to the first semiconductor region during respective transmission periods of the semiconductor laser, and apply the second drive current to the second semiconductor region in intervals between successive transmission periods. The application further relates to a method for driving a semiconductor laser.

## Description

### Technical Field

This application relates to laser assemblies (laser modules) comprising semiconductor lasers, particularly for use in burst-mode operation, and to methods for driving semiconductor lasers, particularly in burst-mode operation. The application relates to both laser modules comprising directly modulated lasers (DMLs) and externally modulated lasers (EMLs).

### Background

Directly tunable lasers, such as e.g. distributed feedback (DFB) lasers and to some degree also other laser types such as EMLs suffer from self-heating induced wavelength drifts during burst-mode operation. In signal processing, this drift results in signal degradations when signals generated by these lasers are passed through narrowband wavelength filters at the receive side, e.g. at the optical line termination (OLT) in a time and wavelength division multiplexed passive optical network (TWDM-PON). This leads to unacceptable transmission errors and instabilities in wavelength stabilization schemes based on e.g. received signal strength indication (RSSI) measurements. Thus, without self-heating mitigation, these lasers are not useable in networks with filter widths in the order of 50 GHz or less.

A number of generic mitigation techniques that are applicable to semiconductor lasers have been proposed so far, e.g. applying accelerated heating, elevated subthreshold bias current or operation at low output powers. However, in order for these mitigation techniques to be efficient, the respective semiconductor laser would need to be driven in a non-optimal point of operation, resulting in system penalties due to e.g. lower power or degraded eye openings.

Thus, there is a need for improved self-heating mitigation techniques applicable to semiconductor lasers.

### Summary

In view of this heed, the present document proposes a laser assembly and a method of driving a semiconductor laser having the features of the respective independent claims.

An aspect of the disclosure relates to a laser assembly (a laser module). The laser assembly may comprise a semiconductor laser and a drive unit for driving the semiconductor laser. The semiconductor laser may comprise a first semiconductor region for generating or modulating an optical signal in response to a first drive current that is injected (applied) to the first semiconductor region and a second semiconductor region that is arranged in proximity to the first semiconductor region and electrically insulated from the first semiconductor region. The drive unit may be configured to generate the first drive current and a second drive current, inject (apply) the first drive current to the first semiconductor region during respective transmission periods (data bursts) of the semiconductor laser, and inject (apply) the second drive current to the second semiconductor region in intervals between successive transmission periods (inter burst gaps, IBGs). The second semiconductor region may be configured to have characteristics of heat generation that are matched to those of the first semiconductor region, e.g. the second semiconductor region and the first semiconductor region may have substantially the same characteristics of heat generation. The second semiconductor region may be configured to not emit any light when injected with the second drive current (i.e. may be optically.inactive, e.g. due to including deep electron traps or being appropriately doped otherwise), or to not emit any light that would be coupled into an optical fiber that is attachable to the semiconductor laser to receive the optical signal generated or modulated by the first semiconductor region. This may require optically insulating the second semiconductor region from the first semiconductor region. In consequence, the first semiconductor region may be referred to as an active region, whereas the second semiconductor region may be referred to as a passive region, or dummy region.

Configured as above, heat is generated in the second semiconductor region during the IBGs and transferred to the first semiconductor region. Thereby, a temperature drop in the first semiconductor region during IBGs may be avoided, or at least mitigated. A difference between the temperature of the first semiconductor region at the beginning of each transmission period and a temperature of the first semiconductor region at the end of the respective transmission period thus vanishes or is at least reduced. Since the drift in emission wavelength depends on the rise of temperature of the first semiconductor region between the beginning of an IBG and the end of the respective IBG, the drift in emission wavelength is altogether avoided or at least mitigated in the above laser assembly. This makes the above the laser assembly a perfect candidate for use e.g. in TWDM-PONs with filter widths of 50 GHz or less, such as a NG-PON2 network.

In embodiments, the first semiconductor region may be one of an active region of a laser section of a semiconductor laser (e.g. a DML or an EML), an active region of an external modulator section of a semiconductor laser (e.g. an EML), or an active region of a semiconductor optical amplifier (SOA). Further, the first semiconductor region may be an active region of any other section of a semiconductor laser that generates heat due to current injection.

In embodiments, the second semiconductor region may have a high frequency response (time response) substantially identical (or at least, similar) to a high frequency response of the first semiconductor region. Likewise, circuitry for driving the second semiconductor region (including wiring and wire bonding; e.g. a circuit path) may have a high frequency response (time response) substantially identical (or at least, similar) to a high frequency response of circuitry for driving the first semiconductor region, i.e. both may be equally (or at least similarly) suitable for high frequency operation.

In embodiments, the second semiconductor region may have substantially the same shape and material composition (e.g. the same doping profile) as the first semiconductor region.

Thereby, a second semiconductor region with appropriate characteristics of heat generation may be obtained in a particularly simple manner, without extensive simulations of heat generation. Moreover, manufacturing of the semiconductor laser is particularly simple since merely the steps that lead to creation of the first semiconductor region need to be repeated. In embodiments, the second semiconductor region may be arranged relative to the first semiconductor region so that heat generated by the second semiconductor region may diffuse to the first semiconductor region and heat up the first semiconductor region. Further, the characteristics of heat generation of the second semiconductor region may be chosen in such a manner that a heat transfer from the second semiconductor region to the first semiconductor region during the intervals between successive transmission periods is dimensioned so that a temperature of the first semiconductor region during the intervals between successive periods of transmission is kept at the same level as during the transmission periods. This translates into the requirement that heat losses of the first semiconductor region during intervals between transmission periods are compensated for by heat transfer from the second semiconductor region to the first semiconductor region. More specifically, the second drive current and the characteristics of heat generation of the second semiconductor region may be chosen to attain this goal. Thereby, the temperature of the first semiconductor region may be kept substantially constant across the transmission periods and the intervals there between.

Configured as above, a drift of the emission wavelength is effectively removed.

In embodiments, the semiconductor laser may further comprise a third semiconductor region that is electrically insulated from the first semiconductor region and arranged in proximity to the first semiconductor region such that the first semiconductor region is sandwiched between the second semiconductor region and the third semiconductor region. The drive unit may be further configured to apply a third drive current to the third semiconductor region in the intervals between successive transmission periods. The third drive current may be identical to the second drive current. The third semiconductor region may be configured to have characteristics of heat generation that are matched to those of the first semiconductor region. The third semiconductor region may be configured to not emit any light when injected with the drive current (i.e. may be optically inactive, e.g. due to including deep electron traps or being appropriately doped otherwise), or to not emit any light that would be coupled into an optical fiber that is attachable to the semiconductor laser to receive the optical signal generated or modulated by the first semiconductor region. This may require optically insulating the third semiconductor region from the first semiconductor region. In consequence, also the third semiconductor region may be referred to as a passive region, or dummy region.

By providing two passive semiconductor regions sandwiching the first semiconductor region, the first semiconductor region may be more uniformly heated and compensation of the drift of the emission wavelength may be further improved.

In embodiments, the third semiconductor region may be arranged relative to the first semiconductor region so that heat generated by the third semiconductor region may diffuse to the first semiconductor region and heat up the first semiconductor region. Further, the characteristics of heat generation of the second and third semiconductor regions may be chosen in such a mannerthat a heattransfer from the second and third semiconductor regions to the first semiconductor region during the intervals between successive transmission periods is dimensioned such that a temperature of the first semiconductor region during the intervals between successive periods of transmission is kept at the same level as during the transmission periods. This translates into the requirement that heat losses of the first semiconductor region during intervals between transmission periods are compensated for by heat transfer from the second and third semiconductor regions to the first semiconductor region. More specifically, the second and third drive currents and the characteristics of heat generation of the second and third semiconductor regions may be chosen to attain this goal. Thereby, the temperature of the first semiconductor region may be kept substantially constant across the transmission periods and the intervals there between.

In embodiments, the third semiconductor region may have a high frequency response (time response) substantially identical (or at least, similar) to a high frequency response of the first semiconductor region. Likewise, circuitry for driving the third semiconductor region (including wiring and wire bonding; e.g. a circuit path) may have a high frequency response (time response) substantially identical (or at least, similar) to a high frequency response of circuitry for driving the first semiconductor region, i.e. both may be equally (or at least similarly) suitable for high frequency operation.

In embodiments, the drive unit is configured to generate the second drive current such that the second drive current is different from zero during at least a portion of each of the intervals between successive transmission periods. For example, the second drive current may relate to a sequence of current pulses that each extend over the full length of a respective interval between successive transmission periods. The same may apply to the third drive current. For example, the third drive current may be identical to the second drive current.

In embodiments, the drive unit may be configured to generate the first drive current on the basis of an input signal comprising a data signal indicative of data to be transmitted by means of the optical signal. The drive unit may be further configured to generate the second drive current on the basis of the first drive current or the input signal.

Thereby, synchronicity between the second drive current and the IBGs can be ensured. Moreover, the second drive current can be specifically adapted to compensate for the heat loss of the first semiconductor region during the IBGs. The reason is that said heat loss depends, among others, on the temperature of the first semiconductor region at the end of the respective transmission period, and said temperature in turn depends on the data transmitted during the respective transmission period, i.e. on the input data.

Another aspect of the disclosure relates to a method of driving a semiconductor laser. The semiconductor laser may comprise a first semiconductor region for generating or modulating an optical signal in response to a first drive current that is applied to the first semiconductor region, and a second semiconductor region that is arranged in proximity to the first semiconductor region and electrically insulated from the first semiconductor region. The second semiconductor region may be configured to have characteristics of heat generation that are matched to those of the first semiconductor region, e.g. the second semiconductor region and the first semiconductor region may have substantially the same characteristics of heat generation. The second semiconductor region may be configured to not emit any light when injected with the second drive current (i.e. may be optically inactive, e.g. due to including deep electron traps or being appropriately doped otherwise), or to not emit any light that would be coupled into an optical fiber attachable to the semiconductor laser to receive the optical signal generated or modulated by the first semiconductor region. This may require optically insulating the second semiconductor region from the first semiconductor region. In consequence, the first semiconductor region may be referred to as an active region, whereas the second semiconductor region may be referred to as a passive region, or dummy region. Each semiconductor region may correspond to a semiconductor layer or part of a semiconductor layer. The method may comprise applying the first drive current to the first semiconductor region during respective transmission periods of the semiconductor laser. The method may further comprise applying a second drive current to the second semiconductor region in intervals between successive transmission periods.

In embodiments, the semiconductor laser may further comprise a third semiconductor region that is electrically insulated from the first semiconductor region and arranged in proximity to the first semiconductor region such that the first semiconductor region is sandwiched between the second semiconductor region and the third semiconductor region. The method mayfurther comprise applying a third drive current to the third semiconductor region in the intervals between successive transmission periods. The third drive current may be identical to the second drive current. The third semiconductor region may be configured to have characteristics of heat generation that are matched to those of the first semiconductor region. The third semiconductor region may be configured to not emit any light when injected with the drive current (i.e. may be optically inactive, e.g. due to including deep electron traps or being appropriately doped otherwise), or to not emit any light that would be coupled into an optical fiber that is attachable to the semiconductor laser to receive the optical signal generated or modulated by the first semiconductor region. This may require optically insulating the third semiconductor region from the first semiconductor region. In consequence, also the third semiconductor region may be referred to as a passive region, or dummy region.

In embodiments, the second drive current may be different from zero during at least a portion of each of the intervals between successive transmission periods. For example, the second drive current may relate to a sequence of current pulses that each extend over the full length of a respective interval between successive transmission periods. The same may apply to the third drive current. For example, the third drive current may be identical to the second drive current.

In embodiments, the method may further comprise generating the first drive current on the basis of an input signal comprising a data signal indicative of data to be transmitted by means of the optical signal, and generating the second drive current on the basis of the first drive current or the input signal.

It will be appreciated that method steps and apparatus features may be interchanged in many ways. In particular, the details of the disclosed apparatus can be implemented as a method, as the skilled person will appreciate.

### Brief Description of the Figures

Embodiments of the disclosure are explained below in an exemplary manner with reference to the accompanying drawings, wherein
Fig. 1 schematically illustrates an example of a semiconductor laser according to embodiments of the disclosure;
Fig. 2 schematically illustrates another example of a semiconductor laser according to embodiments of the disclosure;
Fig. 3 schematically illustrates another example of a semiconductor laser according to embodiments of the disclosure;
Fig. 4 and Fig. 5 schematically illustrate examples of laser assemblies according to embodiments of the disclosure;
Fig. 6 is a schematic timing diagram of time-dependent quantities related to operation of the laser assemblies illustrated in Fig. 4 and Fig. 5;
Fig. 7 and Fig. 8 schematically illustrate further examples of laser assemblies according to embodiments of the disclosure; and
Fig. 9 is a schematic timing diagram of time-dependent quantities related to operation of the laser assemblies illustrated in Fig. 7 and Fig. 8.

### Detailed Description

In a directly modulated laser, such as a DFB laser, the injection current (first drive current) modulates the gain in the DFB section (active section/stripe, gain section/stripe, or first semiconductor region) of the laser. Almost the entire electrical energy is converted into heat, leading to the observed wavelength-drift over time during short data bursts. To prevent occurrence of these wavelength transients during data bursts (during transmission periods) it is proposed to implement an additional dummy section (a second semiconductor region) close to the active section of the laser which is electrically driven during the gaps between data bursts (inter-burst-gaps, IGBs, or intervals between successive transmission periods), thus generating heat even when no optical signals are generated. For instance, a dummy stripe may be provided in parallel to the active stripe.

Then, due to this constant generation of heat in the semiconductor laser during both data bursts and IBGs there will be no more variation of the emission wavelength during the generation of optical signals during data bursts.

It is essential that the heat (and correspondingly, the temperature) in the active section of the laser remains constant over time, irrespective of whether or not optical data is generated. In order to accomplish this, the dummy stripe should be positioned (arranged) close to the active stripe (typically only a few micrometers apart) and preferably have a shape and material composition very similar (e.g. substantially identical) to the active stripe.

However, care must be taken not to generate additional light during the IBGs, or alternatively, to prevent such light that is generated during the IBGs from being coupled into the optical fiber that receives the optical signal output from the semiconductor laser.-This may be ensured by an appropriate design of the laser structure and optionally by an appropriate treatment of the dummy section, e.g. by introducing deep level electronic traps into the dummy section for reducing the radiative electron-hole recombination rate or by otherwise doping the dummy section to prevent emission of light. ,

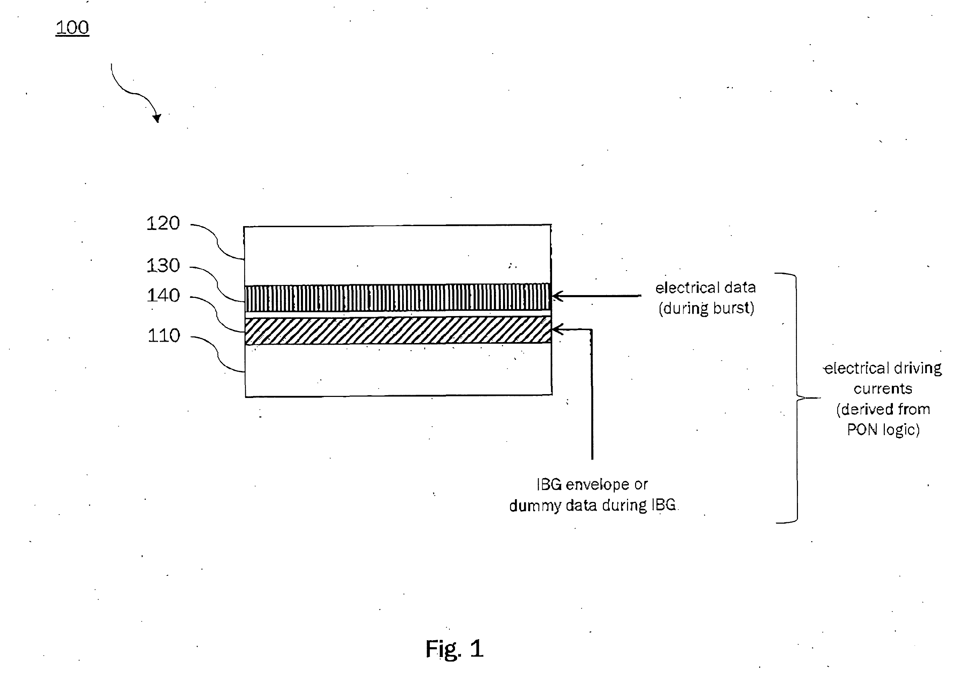

Fig. 1 schematically illustrates an example of a semiconductor laser 100 according to embodiments of the disclosure. The semiconductor laser 100 comprises a semiconductor material 110, 120, a first semiconductor region (active region, active stripe) 130 for generating or modulating an optical signal in response to a first drive current that is applied to the first semiconductor region 130 during transmission periods (but not during IBGs), and a second semiconductor region (dummy region, dummy stripe) 140. The second semiconductor region 140 may be arranged in proximity to the first semiconductor region such that heat generated in the second semiconductor region 140 may diffuse to the first semiconductor region 130. The second semiconductor region 140 may be arranged in parallel to the first semiconductor region 130. Further, the second semiconductor region 140 may be electrically insulated from the first semiconductor region 130. This may be achieved e.g. by providing an appropriate doping profile between the first semiconductor region 130 and the second semiconductor region 140 (i.e. by providing an insulation layer), or by providing an air-filled gap between the first semiconductor region 130 and the second semiconductor region 140. Moreover, the second semiconductor region 140 may be optically inactive and/or be optically insulated from the first semiconductor region 130, as indicated above.

The above reference to a directly modulated laser, such as a DFB laser, is understood to indicate an example, without intended limitation of the present disclosure. In general, the first semiconductor region may be one of an active region of a laser section of a semiconductor laser (e.g. a DML or an EML), an active region of an external modulator section of a semiconductor laser (e.g. an EML), or an active region of an SOA. Further, the first semiconductor region may be an active region of any other section of a semiconductor laser that generates heat due to current injection.

The second semiconductor region 140 may be electrically driven by a second drive current during the IGBs, but not during the transmission periods. The second drive current may relate e.g. to a single current pulse lasting over the entire duration of the IBG or to a sequence of current pulses representing a sequence of dummy data (e.g. a "1010" sequence) during the IBG. In the former case the second semiconductor region 140 needs to handle lower electrical bandwidths (typically few MHz) as compared to the latter case (few GHz) and may therefore be the preferred case. Notably, there is freedom in the choice of the signal structure of the second drive current, as long as requirements described further below are met.

The second semiconductor region 140 may have characteristics of heat generation (e.g. indicative of a time dependence of heat generation and an amount of heat generation in dependence on an injected drive current) matched to those of the first semiconductor region 130. For instance, the characteristics of heat generation of the second semiconductor region may be substantially identical to those of the first semiconductor region 130. This may be achieved by providing the second semiconductor region with the same shape and material composition (e.g. same doping profile) as the first semiconductor region 130.

In most general terms, the requirements for the structure of the second drive current and for the characteristics of heat generation of the second semiconductor region 140 are that the amount of heatgenerated by the second semiconductor region 140 driven by the second drive current and arriving in the first semiconductor region 130 during the IGBs must be identical to the heat generated by the first semiconductor region 130 during the real data bursts. Said heat generated by the second semiconductor region 140 depends on both the second drive current and the characteristics of heat generation of the second semiconductor region 140. It may be further required to also take into account time constants and losses in the heat transfer between the second semiconductor region 140 and the first semiconductor region 130, which may depend on the relative arrangement of the first and second semiconductor regions 130,140,

In other words, the characteristics of heat generation of the second semiconductor region 140 and the second drive current need to be chosen in such a manner that a heat transfer from the second semiconductor region 140 to the first semiconductor region 130 during the IBGs is dimensioned so that a temperature of the first semiconductor region 130 during the IBGs is kept at the same level as during the transmission periods, i.e. so that the temperature of the first semiconductor region 130 is kept substantially constant across transmission periods and IBGs during operation in burst mode.

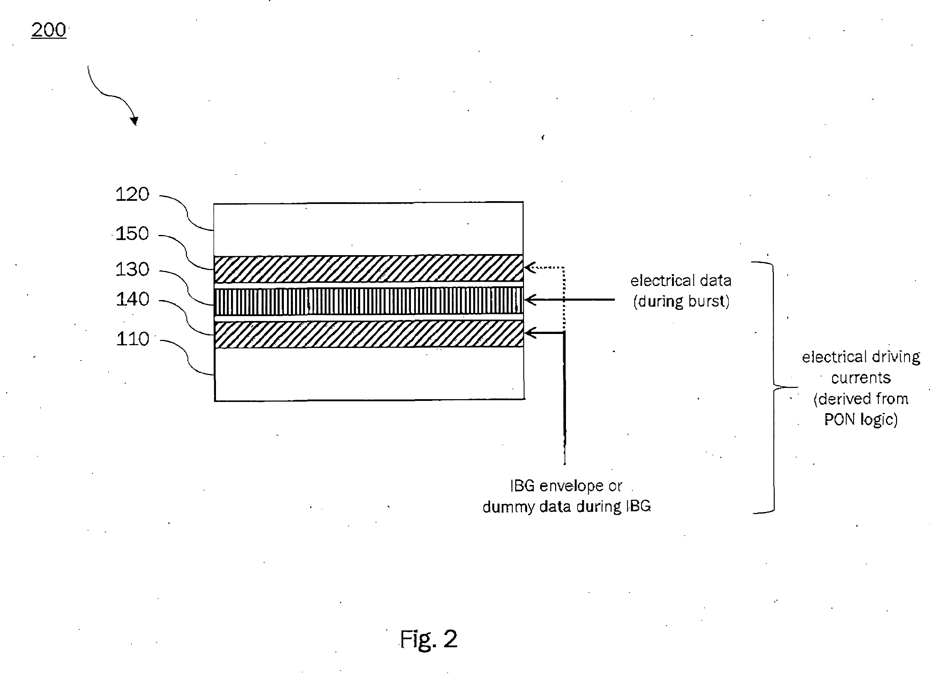

In embodiments, two dummy sections may be implemented, one on either side of the active stripe. This situation is illustrated in Fig. 2. The semiconductor laser 200 illustrated in Fig. 2 comprises the regions described above in connection with Fig. 1, and additionally a third semiconductor region (dummy region, dummy section, dummy stripe) 150. The second and third semiconductor regions 140, 150 are sandwiching the first semiconductor region 130. The third semiconductor region 150 may be arranged in proximity to the first semiconductor region such that heat generated in the third semiconductor region 150 may diffuse to the first semiconductor region 130. The third semiconductor region 150 may be arranged in parallel to the first semiconductor region 130. Further, the third semiconductor region 150 may be electrically insulated from the first semiconductor region 130. This may be achieved e.g. by providing an appropriate doping profile between the first semiconductor region 130 and the third semiconductor region 150 (i.e. by providing an insulation layer), or by providing an air-filled gap between the first semiconductor region 130 and the third semiconductor region 150. Moreover, the third semiconductor region 150 may be optically inactive and/or be optically insulated from the first semiconductor region 130. This may be achieved in the same manner as described above in connection with the second semiconductor region 140.

The third semiconductor region 150 may be electrically driven by a third drive current during the IGBs, but not during the transmission periods. Similar to the second drive current, the third drive current may relate e.g. to a single current pulse lasting over the entire duration of the IBG or to a sequence of current pulses representing a sequence of dummy data (e.g. a "1010" sequence) during the IBG. For simplicity, the third drive current may be identical to the second drive current.

The third semiconductor region 150 may have characteristics of heat generation (e.g. indicative of a time dependence of heat generation and an amount of heat generation in dependence on an injected drive current) matched to those of the first semiconductor region 130. For instance, the characteristics of heat generation of the third semiconductor region 150 may be substantially identical to those of the first semiconductor region 130.

In any case, the characteristics of heat generation of the third semiconductor region 150 and the third drive current need to be chosen in such a manner that a heat transfer from the third semiconductor region 150 to the first semiconductor region 130 during the IBGs is dimensioned so that a temperature of the first semiconductor region 130 during the IBGs. is kept at the same level as during the transmission periods. More precisely, the characteristics of heat generation of the second and third semiconductor regions 140, 150 and the second and third drive currents need to be chosen in such a manner that a heat transfer from the second and third semiconductor regions 140, 150 to the first semiconductor region 130. during the IBGs is dimensioned so that a temperature of the first semiconductor region 130 during the IBGs is kept at the same level as during the transmission periods.

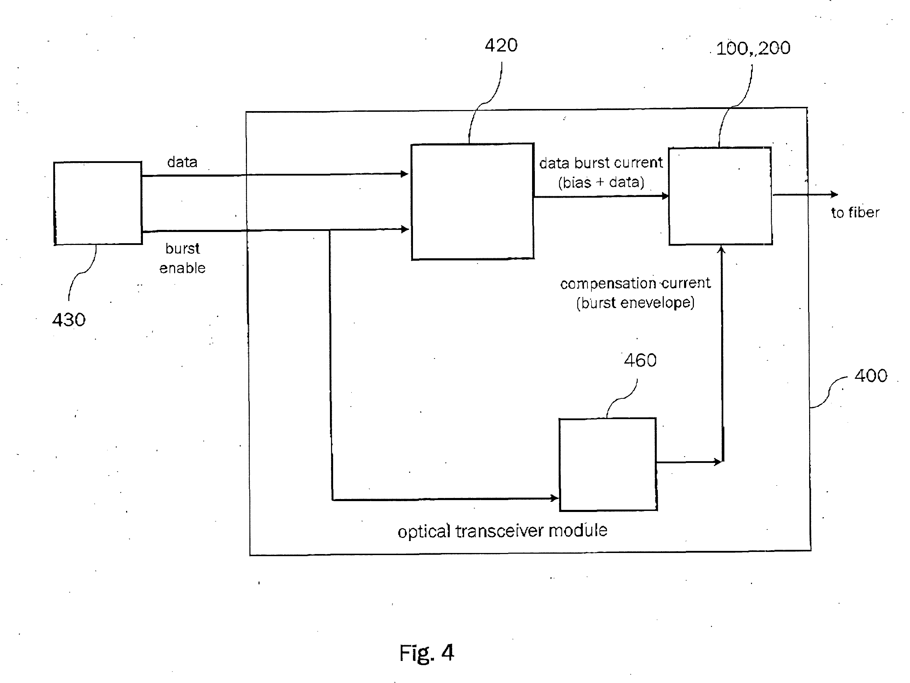

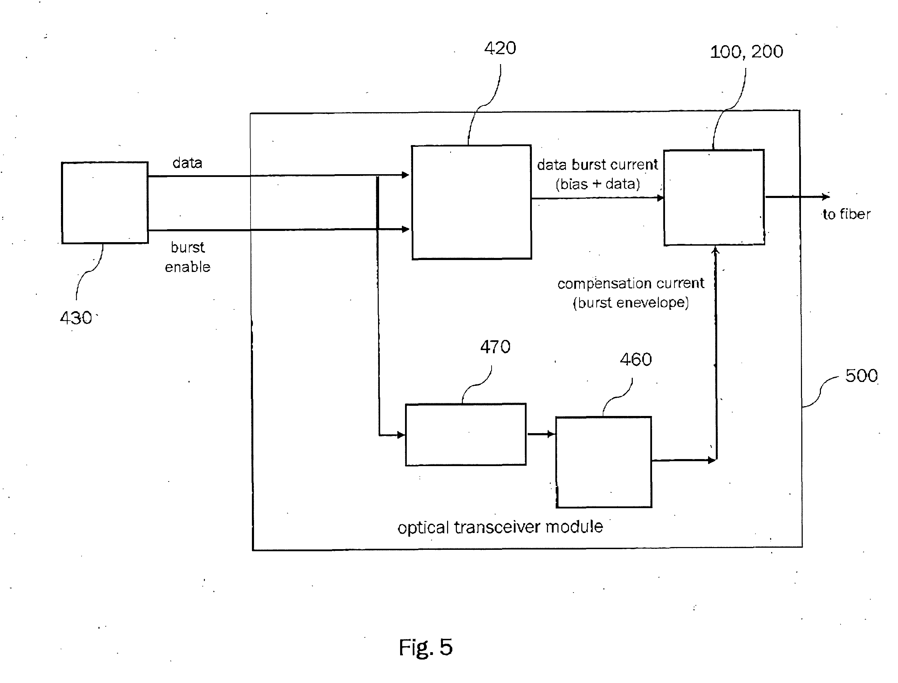

Fig. 4 and Fig. 5 schematically illustrate examples of laser assemblies (laser modules) 400, 500 according to embodiments of the disclosure, which may comprise each of the above described semiconductor lasers 100, 200.

Both laser assemblies 400, 500 comprise a semiconductor laser 100, 200 as described above, and a drive circuit (laser driver) 420 for driving the first semiconductor region 130 of the semiconductor laser 100, 200, i.e. for generating the first drive current for the semiconductor laser 100, 200. The laser assembly 400, 500 receives an input signal from a logic circuit (e.g. a PON logic) 430 that is fed to the drive circuit 420. The laser assemblies 400, 500 further comprise a pulse generation circuit (pulse generator) 460. The laser assembly 500 in **Fig. 5** further comprises an averaging circuit (averager) 470.

The input signal generated by the logic circuit 430 may comprise a burst enable signal (a sequence of rectangular pulses, each rectangular pulse corresponding to a respective transmission period) indicating transmission periods of the semiconductor laser 100, 200 and biasing the semiconductor laser 100, 200 at its operation point, and a data signal indicating actual data to be transmitted by means of optical emission by the semiconductor laser 100, 200. The burst enable signal and the data signal are fed to the drive circuit 420. The drive circuit 420 generates the first drive current that is applied to the first semiconductor region 130 of the semiconductor laser 100, 200 on the basis of the input signal, i.e. on the basis of the burst enable signal and/or the data signal. The first drive current is zero during the IBGs, i.e. a drive current is not applied to the first semiconductor region 130 during the IBGs.

In the laser assembly 400 in Fig. 4, the burst enable signal is additionally fed to the pulse generation circuit 460. The pulse generation circuit 460 generates, on the basis of the burst enable signal, the second drive current that is applied to the second semiconductor region 140 and, if present, also to the third semiconductor region 150. For example, the second drive current may be generated to be proportional to the inverted burst enable signal, or to correspond to a dummy sequence during the IBGs (i.e. when the burst enable signal is zero). The second drive current is zero during the transmission periods, i.e. a drive current is not applied to the second semiconductor region 140 (and the third semiconductor region 150) during transmission periods.

In the laser assembly 500 in Fig. 5, the data signal is fed to the averaging circuit 470. The averaging circuit 470 may be implemented by a suitable low pass filter, The averaging circuit 470 generates an envelope of the data signal e.g. by averaging the data signal. The generated envelope is fed to the pulse generation circuit 460. The pulse generation circuit 460 generates, on the basis of the envelope of the data signal, the second drive current that is applied to the second semiconductor region 140 and, if present, also to the third semiconductor region 150. For example, the second drive current may be generated to be proportional to the inverted envelope of the data signal, or to correspond to a dummy sequence during the IBGs (i.e. when the envelope of the data signal is zero).

In the above, the drive circuit 420 and the pulse generation circuit 460 in the case of Fig. 4 and the drive circuit 420, the pulse generation circuit 460, and the averaging circuit 470 in the case of Fig. 5 may be said to form a drive unit for driving the semiconductor laser 100, . 200. The drive unit generates the first and second drive currents. The drive unit further applies the first drive current to the first semiconductor region 130, and the second drive current to the second semiconductor region 140 (and the third semiconductor region 150, if present). The (non-zero) first drive current is applied to the first semiconductor region 130 during the transmission periods, and the (non-zero) second drive current is applied to the second semiconductor region 140 (and the third semiconductor region 150, if present) during the IBGs.

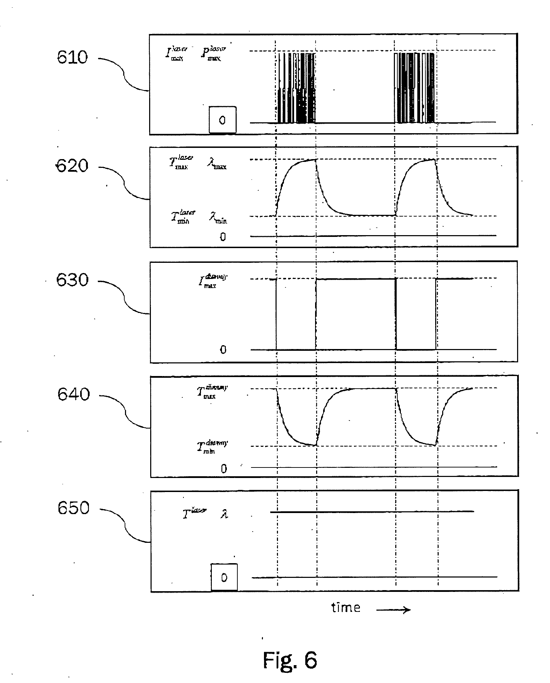

Fig. 6 is an exemplary schematic timing diagram of time-dependent quantities related to operation of the laser assemblies 400 and 500 illustrated in Fig. 4 and Fig. 5. The topmost diagram 610 indicates an example of the first drive current output by the drive circuit 420 and injected to the first semiconductor region 130 of the semiconductor laser 100, 200, and the output optical power of the semiconductor laser 100, 200. In this schematic representation, the first drive current and the output optical power are illustrated to have qualitatively the same variation in time. The second diagram 620 from the top indicates an example of the laser temperature within the first semiconductor region 130 and the emission wavelength of the optical signal output by the semiconductor laser 100, 200 during data bursts, both for a case in which the self-heating mitigation technique according to the disclosure is not applied. Also the laser temperature and the emission wavelength are schematically illustrated to have qualitatively the same variation in time. Needless to say, the emission wavelength Is understood to be zero during intervals between data bursts. The third diagram 630 from the top Indicates an example of the second drive current that is applied to the second semiconductor region 140 (and the third semiconductor region 150, if present). The fourth diagram 640 from the top indicates an example of the temperature of the first semiconductor region 130 induced by heat generated in the second semiconductor region 140 (and the third semiconductor region 150, if present), ignoring any heat generated by the first semiconductor region 130 during transmission periods. The lowermost diagram 650 indicates an example of the net temperature of the first semiconductor region 130 and the emission wavelength of the optical signal output by the semiconductor laser 100, 200 during data bursts for the case in which the self-heating mitigation technique according to the disclosure is applied. Also the net temperature and the emission wavelength are schematically illustrated to have qualitatively the same variation in time.

As can be seen from Fig. 6, without applied self-heating mitigation technique, the laser temperature rises during data bursts, and the emission wavelength of the optical signal increases proportionally to the temperature increase. The second drive current has a constant level during the IBGs, and is zero during the transmission periods. Further, the heat transferred to the first semiconductor region 130 during the IBGs prevents a cooling off of the first semiconductor region 130 during the IBGs and keeps constant the temperature of the first semiconductor region 130 across periods of transmission and IBGs. Accordingly, if the self-heating mitigation technique according to the disclosure is applied, the emission wavelength of the optical signal is substantially constant over time during data bursts.

The above considerations are easily adapted to other than directly modulated laser structures. For example, In case of an externally modulated laser (EML), the transient heat generation occurs in the electrical absorption modulator (EAM) as well as in the gain section, if the laser section is activated only during bursts. If an additional on-chip SOA is used, e.g. for power levelling or for boosting the output power, then also this element will generate heat bursts on the chip. In all these cases additional dummy heating sections will help keep the temperature of the active stripe constant over time, thus preventing wavelength drifts. A dummy section can be specially designed to compensate for the net effect of all the transient heat generation in the different sections of the semiconductor laser. This requires thermal modelling of the laser structure. An alternate and possibly simpler approach is to just copy the respective heat generating sections of the laser structure and place them as dummy elements next to the original elements and drive them during the IBGs with appropriate electrical currents, as discussed above.

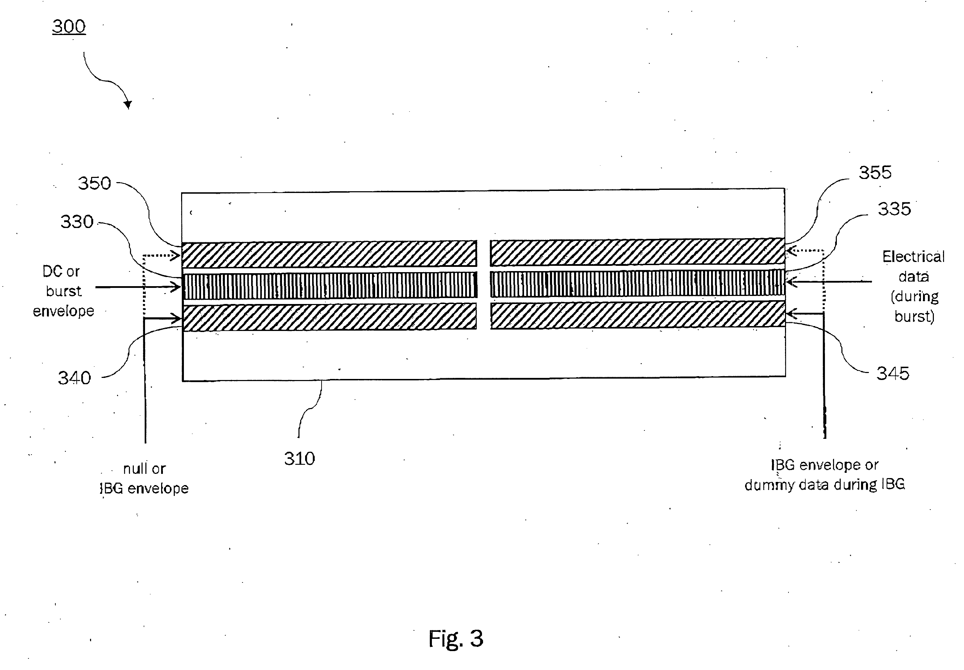

Fig. 3 schematically illustrates another example of a semiconductor laser 300 according to embodiments of the disclosure, which is an EML. The semiconductor laser 300 comprises a laser section (left-hand side) and an external modulator section (right-hand side). The externally modulated optical signal is emitted from the semiconductor laser 300 in a direction pointing to the right in Fig. 3. The laser section comprises a first semiconductor region 330 which is an active section for generating an optical signal as well as second and third semiconductor regions 340, 350, which are dummy sections. Either one of the second and third semiconductor regions 340, 350 may be omitted. The external modulator section comprises a first semiconductor region 335, which is an active section for modulating the optical signal generated by the first semiconductor region 330 of the laser section, as well as second and third semiconductor regions 345, 355, which are dummy sections. Either one of the second or third semiconductor regions 345, 355 of the external modulation section may be omitted. The first semiconductor region 330 of the laser section is driven by a first drive current for the laser section, and the second and third semiconductor regions 340,350 of the laser section are driven by a second drive current for the laser section. The first semiconductor region 335 of the external modulator section is driven by a first drive current for the external modulator section, and the second and third semiconductor regions 345, 355 of the external modulator section are driven by a second drive current for the external modulator section. It is understood that any statements made earlier with respect to the second and third semiconductor regions and respective drive currents also apply to the configuration illustrated in Fig. 3.

By providing the second and/or third semiconductor region 345, 355 of the external modulator section, an amount of heat generated by the external modulator section can be kept constant across transmission periods and IBGs. Accordingly, an amount of heat transferred to the laser section is constant over time and will not cause a drift of the emission wavelength of the first semiconductor region of the laser section. In other words, operating the external modulator section in burst mode does not cause a drift of the emission wavelength of the laser section.

Likewise, one or more dummy regions may be provided for any other active region of a semiconductor laser that generates heat due to current injection, such as the active region of an SOA. Thereby, an amount of heat that Is transferred to the laser section is kept constant over time and will not cause a drift of the emission wavelength of the laser section of the semiconductor laser.

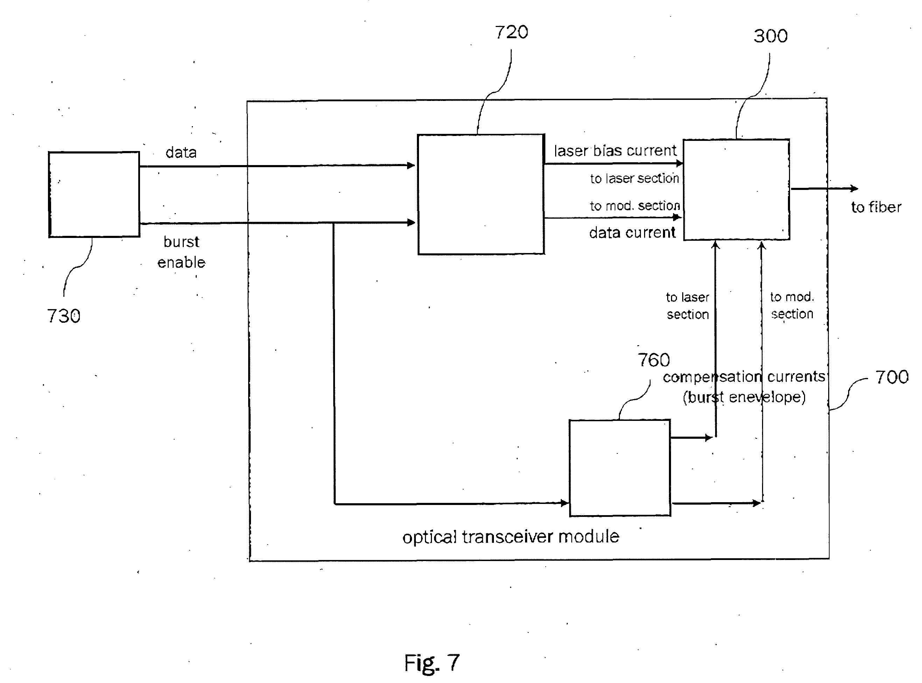

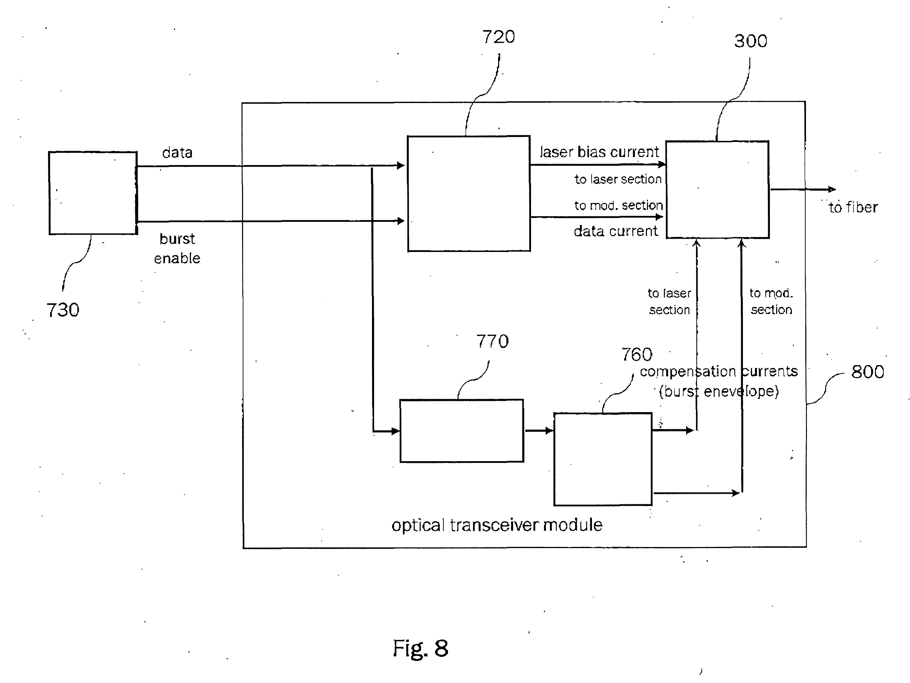

Fig. 7 and Fig. 8 schematically illustrate further examples of laser assemblies (laser modules) 700, 800 according to embodiments of the disclosure, which may comprise the semiconductor laser 300 described with reference to Fig. 3. Unless indicated otherwise, statements analogous to those made earlier with respect to corresponding components of the respective laser assemblies in Fig. 4 and Fig. 5 are understood to apply also here.

Both laser assemblies 700, 800 comprise a semiconductor laser 300 as described above, and a drive circuit (laser driver) 720 for driving the first semiconductor regions 330, 335 of the laser section and the external modulator section of the semiconductor laser 300, i.e. for generating the first drive current for the laser section and the first drive current for the external modulator section of the semiconductor laser 300. The laser assembly 700, 800 receives an input signal from a logic circuit (e.g. a PON logic) 730 that is fed to the drive circuit 720. The laser assemblies 700, 800 further comprise a pulse generation circuit (pulse generator) 760. The laser assembly 800 in Fig. 8 further comprises an averaging circuit (averager) 770.

The input signal generated by the logic circuit 730 corresponds to that described above with reference to Fig. 4 and Fig. 5 and may comprise a burst enable signal and a data signal. The burst enable signal and the data signal are fed to the drive circuit 720. The drive circuit 720 generates the first drive current for the laser section that is applied to the first semiconductor region 330 of the laser section of the semiconductor laser 300 on the basis of the input signal, i.e. on the basis of the burst enable signal and/or the data signal. The drive circuit 720 further generates the first drive current for the external modulator section that is applied to the first semiconductor region 335 of the external modulator section of the semiconductor laser 300 on the basis of the input signal, i.e. on the basis of the burst enable signal and/or the data signal.

In the laser assembly 700 in Fig. 7, the burst enable signal is additionally fed to the pulse generation circuit 760. The pulse generation circuit 760 generates, on the basis of the burst enable signal, the second drive current for the laser section that is applied to the second semiconductor region 340 and, if present, also to the third semiconductor region 350 of the laser section of the semiconductor laser 300. Further, the pulse generation circuit 760 generates, on the basis of the burst enable signal, the second drive current for the external modulator section that is applied to the second semiconductor region 345 and, if present, also to the third semiconductor region 355 of the external modulator section of the semiconductor laser 300.

In the laser assembly 800 in Fig. 8, the data signal is fed to the averaging circuit 770. The averaging circuit 770 generates an envelope of the data signal e.g. by averaging the data signal. The generated envelope is fed to the pulse generation circuit 760. The pulse generation circuit 760 generates, on the basis of the envelope of the data signal, the second drive current for the laser section of the semiconductor laser 300 that is applied to the second semiconductor region 340 and, if present, also to the third semiconductor region 350 of the laser section of the semiconductor laser 300. The pulse generation circuit 760 further generates, on the basis of the envelope of the data signal, the second drive current for the external modulator section of the semiconductor laser 300 that is applied to the second semiconductor region 345 and, if present, also to the third semiconductor region 355 of the external modulator section of the semiconductor laser 300.

In the above, the drive circuit 720 and the pulse generation circuit 760 in the case of Fig. 7 and the drive circuit 720, the pulse generation circuit 760, and the averaging circuit 770 in the case of Fig. 8 may be said to form a drive unit for driving the semiconductor laser 300. The drive unit generates the first and second drive currents. The drive unit further applies the first drive currents to respective first semiconductor regions 330, 335, and applies the second drive currents to respective second semiconductor regions 340, 345 (and respective third semiconductor regions 350, 355, if present).

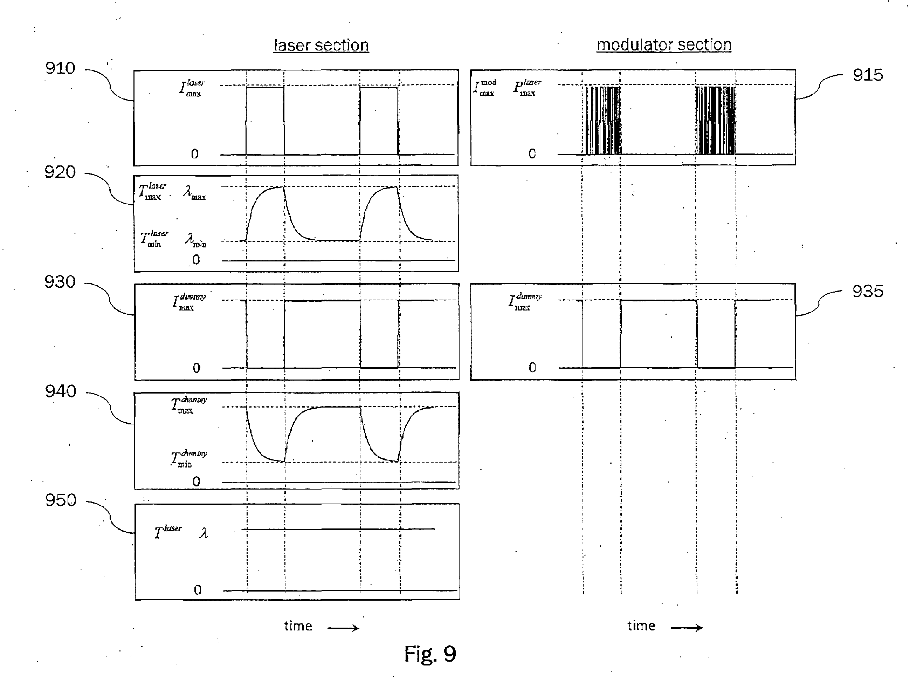

Fig. 9 is a schematic timing diagram of time-dependent quantities related to operation of the laser assemblies illustrated in Fig. 7 and Fig. 8. The topmost diagrams 910, 915 indicate an example of the first drive current for the laser section of the semiconductor laser output by the drive circuit 720 and injected to the first semiconductor region 330 of the laser section of the semiconductor laser 300 (left diagram) and an example of the first drive current for the external modulator section of the semiconductor laser output by the drive circuit 720 and injected to the first semiconductor region 335 of the external modulator section of the semiconductor laser 300 and the output optical power of the semiconductor laser 300 (right diagram). In this schematic representation, the first drive current for the external modulator section and the output optical power are illustrated to have qualitatively the same variation in time. The second diagram 920 from the top indicates an example of the laser temperature within the first semiconductor region 330 of the laser section and the emission wavelength of the optical signal output by the semiconductor laser 300 during data bursts, both for a case in which the self-heating mitigation technique according to the disclosure is not applied. Also the laser temperature and the emission wavelength are schematically illustrated to have qualitatively the same variation in time. Needless to say, the emission wavelength is understood to be zero during intervals between data bursts. The third diagrams 930, 935 from the top indicate an example of the second drive current for the laser section that is applied to the second semiconductor region 340 (and the third semiconductor region 350, if present) of the laser section (left diagram) and an example of the second drive current for the external modulator section that is applied to the second semiconductor region 345 (and the third semiconductor region 355, if present) of the external modulator section (right diagram). The fourth diagram 940 from the top indicates an example of the temperature of the first semiconductor region 330 of the laser section, ignoring any heat generated by the first semiconductor regions 330, 335 during transmission periods. The lowermost diagram.950 indicates an example of the net temperature of the first semiconductor region 330 of the semiconductor laser 300 and the emission wavelength of the optical signal output by the semiconductor laser 300 during data bursts for the case in which the self-heating mitigation technique according to the disclosure is applied. Also the net temperature and the emission wavelength are schematically illustrated to have qualitatively the same variation in time.

As can be seen from the topmost left diagram 910 of Fig. 9, the laser section is driven only during transmission periods. Alternatively, the laser section could be driven continuously. This case is not reflected in the remaining diagrams.

As can be further seen from Fig. 9, without applied self-heating mitigation technique, the laser temperature rises during data bursts, and the emission wavelength increases proportionally to the temperature increase. The second drive currents have a constant level during the IBGs, and are zero during the transmission periods. Further, the heat that is transferred to the first semiconductor regions 330, 335 during the IBGs prevents a cooling off of the first semiconductor regions 330, 335 during the IBGs and keeps constant the temperature of the first semiconductor regions 330, 335 across periods of transmission and IBGs. Accordingly, if the self-heating mitigation technique according to the disclosure is applied, there is no cooling off of the first semiconductor regions 330, 335 between data bursts and the emission wavelength of the optical signal is substantially constant over time during data bursts.

It should be noted that the apparatus features described above correspond to respective method features that are however not explicitly described, for reasons of conciseness. The disclosure of the present document is considered to extend also to such method features.

It should be further noted that the description and drawings merely illustrate the principles of the proposed apparatus. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed apparatus. Furthermore, all statements herein providing principles, aspects, and embodiments of the invention, as well as specific examples thereof, are intended to encompass equivalents thereof.

## Claims

1. A laser assembly comprising a semiconductor laser and a drive unit for driving the semiconductor laser,
wherein the semiconductor laser comprises:
a first semiconductor region for generating or modulating an optical signal in response to a first drive current that is applied to the first semiconductor region;
a second semiconductor region that is arranged in proximity to the first semiconductor region and electrically insulated from the first semiconductor region,
wherein the drive unit is configured to generate the first drive current and a second drive current, apply the first drive current to the first semiconductor region during respective transmission periods of the semiconductor laser, and apply the second drive current to the second semiconductor region in intervals between successive transmission periods.

2. The laser assembly according to claim 1, wherein the second semiconductor region is configured to have characteristics of heat generation that are matched to those of the first semiconductor region.

3. The laser assembly according to claim 1 or 2, wherein the second semiconductor region has substantially the same shape and material composition as the first semiconductor region.

4. The laser assembly according to any one of claims 1 to 3, wherein the second semiconductor region is arranged so that heat generated by the second semiconductor region may diffuse to the first semiconductor region and heat up the first semiconductor region.

5. The laser assembly according to claim 4, wherein the characteristics of heat generation of the second semiconductor region are chosen in such a manner that a heat transfer from the second semiconductor region to the first semiconductor region during the intervals between successive transmission periods is dimensioned so that a temperature of the first semiconductor region during the intervals between successive periods of transmission is kept at the same level as during the transmission periods.

6. The laser assembly according to anyone of claims 1 to 5, wherein the second semiconductor region is optically inactive and/or is optically insulated from the first semiconductor region.

7. The laser assembly according to any one of claims 1 to 6, wherein the semiconductor laser further comprises a third semiconductor region that is electrically insulated from the first semiconductor region and arranged in proximity to the first semiconductor region such that the first semiconductor region is sandwiched between the second semiconductor region and the third semiconductor region; and
wherein the drive unit is further configured to apply a third drive current to the third semiconductor region in the intervals between successive transmission periods.

8. The laser assembly according to claim 7, wherein the third semiconductor region is arranged so that heat generated by the third semiconductor region may diffuse to the first semiconductor region and heat up the first semiconductor region.

9. The laser assembly according to claim 8, wherein the characteristics of heat generation of the second and third semiconductor regions are chosen in such a manner that a heat transfer from the second and third semiconductor regions to the first semiconductor region during the intervals between successive transmission periods is dimensioned to keep a temperature of the first semiconductor region during the intervals between successive periods of transmission at the same level as during the transmission periods.

10. The laser assembly according to any one of claims 1 to 9, wherein the drive unit is configured to generate the second drive current such that the second drive current is different from zero during at least a portion of each of the intervals between successive transmission periods.

11. The laser assembly according to any one of claims 1 to 10, wherein the drive unit is configured to generate the first drive current on the basis of an input signal comprising a data signal indicative of data to be transmitted by means of the optical signal; and
wherein the second drive current is generated on the basis of the input signal.

12. A method of driving a semiconductor laser having a first semiconductor region for generating or modulating an optical signal in response to a first drive current that is applied to the first semiconductor region, and a second semiconductor region that is arranged in proximity to the first semiconductor region and electrically insulated from the first semiconductor region, wherein the second semiconductor region is configured to have characteristics of heat generation that are matched to those of the first semiconductor region, the method comprising:
applying the first drive current to the first semiconductor region during respective transmission periods of the semiconductor laser; and
applying a second drive current to the second semiconductor region in the intervals between successive transmission periods.

13. The method according to claim 12,
wherein the semiconductor laser further comprises a third semiconductor region that is electrically insulated from the first semiconductor region and arranged in proximityto the first semiconductor region such that the first semiconductor region is sandwiched between the second semiconductor region and the third semiconductor region; and
wherein the method further comprises applying a third drive current to the third semiconductor region in the intervals between successive transmission periods.

14. The method according to claim 12 or 13, wherein the second drive current is different from zero during at least a portion of each of the intervals between successive transmission periods.

15. The method according to any one of claims 12 to 14, further comprising:
generating the first drive current on the basis of an input signal comprising a data signal indicative of data to be transmitted by means of the optical signal; and generating the second drive current on the basis of the input signal.
